# EUROPEAN PATENT APPLICATION

(11) **EP 1 997 937 A1**
(43) Date of publication of application: **03.12.2008**
(21) Application number: 07108546.8
(22) Date of filing: 21.05.2007
(51) Int. Cl.: C23C 28/00, F16H 55/06, F16H 1/00, C23C 16/02, C23C 16/27

(54) **Aluminium gear with hard carbon coating**

(71) Applicant: NV Bekaert SA, 8550 Zwevegem (BE)
(72) Inventor: PALMERS, Johan, 7750 Amougies (BE)
(74) Representative: Messely, Marc

(57) **Abstract**

A gear (10) has been adapted to transmit power in a car or a motor bike and has been made of an aluminium alloy. The gear (10) comprises teeth (14), which are at least partially covered with a layered coating (20, 22, 24). The layered coating comprises an intermediate coating (22) and a hard carbon coating (24) on top of the intermediate coating. The intermediate coating comprises a metal layer with at least one element of group IVB, group VB or group VIB.

## Description

### Technical Field

The present invention relates to a gear adapted to transmit power in a car or a motor bike. The present invention relates particularly to the use of such a gear in racing motor bikes.

### Background Art

In the field of automotive there is a continuous request for saving weight whilst maintaining and even increasing performance parameters such as speed and power. This request is even more pronounced in moving parts which transmit power. The weight must be lowered, since this lowers the moment of inertia and allows increasing the speed. This continuous and increasing pressure on saving weight, however, encounters limits as low-weight materials are often less strong.

With respect to gears, e.g. the gears that transmit the power coming from the motor to the wheels through a chain, those gears are commonly made of steel. Steel gears have been replaced successfully by titanium gears. Titanium gears, however, are much more expense than the steel gears.

Attempts have been made in the past to apply aluminium gears. Whilst providing a solution to the weight issue, these gears are not strong enough and only have a limited life time.

### Disclosure of Invention

It is a general aspect of the invention to avoid the problems of the prior art. It is an aspect of the invention to provide a gear which offers both a weight saving and an acceptable life time.
It is another aspect of the invention to provide a gear with a lower weight without being very expensive.
It is still another aspect of the invention to provide a gear which allows a more efficient power transmission.

These aspects are realized by a gear which is adapted to transmit power in a car or a motor bike, e.g. a racing car or a racing motor bike. The gear is made of an aluminium alloy in order to save weight. The gear comprises teeth and the teeth are at least partially covered with a layered coating. The layered coating comprises an intermediate coating and a hard carbon coating on top of the intermediate coating.
The intermediate coating comprises a metal layer comprising at least one element of group IVB, group VB or group VIB: Ti, Zr, Hf, V, Nb, Ta, Cr, Mo, W. The most preferable element is Ti. Due to this intermediate coating a good adhesion between the aluminium substrate and the hard carbon coating is obtained.
The hard carbon coating is e.g. a diamond-like carbon coating (DLC) obtainable by means of a chemical vapour deposition (CVD) process or by means of a plasma assisted chemical vapour deposition (PACVD) process.

An intermediate coating as described here above and a hard carbon coating on top of it, are known as such and are disclosed e.g. in WO-A1-2005/054540 and in WO-A1-2005/014882. Despite the existence of these coatings it was not a priori certain that these coatings would function adequately on an aluminium substrate because of following reason. Hard coatings such as hard carbon coatings as diamond-like carbon coatings may provide an increased hardness and reduction in coefficient of friction on substrates on condition that the substrate already has a certain level of hardness. Applying a very hard coating on a very soft substrate makes no sense, since the hard coating will not hold on the soft substrate. So there was already a resistance against applying a hard carbon coating on aluminium. In addition thereto, as already mentioned, diamond-like carbon coatings are applied by means of a CVD or PACVD process. Both processes necessitate the heating of the substrate to about 200°C and this heating causes some additional loss of hardness to aluminium. This loss in hardness reinforced the prevailing opinion against trying to coat aluminium.

In spite of the general opinion, the inventors have tried to deposit the above-mentioned layered coating on an aluminium gear with success. The thus coated aluminium gear has ended up in a life time which is eight times the life time of an aluminium gear without such coating.

In an aspect of the invention, the intermediate coating may further comprise a nitride layer deposited on the metal layer. The nitride layer comprises at least one nitride of an element of group IVB, group VB or group VIB. For example the nitride layer comprises TiN or CrN. The intermediate coating may have following layers:
- a first metal layer deposited on the substrate, said first metal layer comprising at least one element of group IVB, group VB or group VIB;
- a nitride layer deposited on said first metal layer, said nitride layer comprising at least one nitride of an element of group IVB, group VB or group VIB;
- a second metal layer deposited on said nitride layer, said second metal layer comprising at least one element of group IVB, group VB or group VIB;
- a transition layer deposited on said second metal layer, said transition layer comprising at least one carbide of an element of group IVB, group VB or group VIB.

In another aspect of the invention, the hard carbon coating comprises a layer with a diamond-like nanocomposite composition and a layer with a diamond-like carbon composition.

A diamond-like nanocomposite (DLN) composition comprises an amorphous structure of C, H, Si and O. Preferably, the diamond-like nanocomposite composition comprises in proportion to the sum of C, Si and O: 40% to 90% C, 5% to 40% Si, and 5% to 25% of O, all percentages being atomic percentages. The diamond-like nanocomposite composition may or may not be doped with elements such as transition metals out of Group IV to VII. Examples of doping elements are W, Zr, Ti, F.

A diamond-like carbon (DLC) composition comprises amorphous hydrogenated carbon (A-C:H). Preferably, a diamond-like carbon coating comprises a mixture of sp² and sp³ bonded carbon with a hydrogen concentration between 0 and 60 atomic per cent.
The DLC composition may also be doped, e.g. by W, Zr, Ti.

The intermediate coating may have a thickness ranging from 10 nm to 1000 nm, e.g. from 100 nm to 500 nm.

The DLN coating may have a thickness ranging from 20 nm to 2000 nm, e.g. from 50 nm to 1000 nm.

The DLC coating may have a thickness greater than 100 nm, e.g. greater than 250 nm, e.g. greater than 400 nm.

Normally the DLC coating forms the top coating. A thin DLN coating on top of the DLC coating, however, is not excluded. The combination of DLN and DLC coatings is disclosed e.g. in EP-B1-0 963 455 and in WO-A1-2006/125613.

Both the DLN coating and the DLC coating are applied by means of a CVD or PACVD process, one immediately following the other. This means that a sudden and strict separation between the DLN coating and the DLC coating is often not present. Instead, the amounts of Si and O gradually decrease and disappear and the amounts of C and H gradually increase. In other words, there is a transition zone between the DLN coating and the DLC coating.

The gear substrate is made of an aluminium alloy with one or more of following alloying elements: Cu, Si, Mn, Mg, Zn. A suitable aluminium alloy is aluminium 7075 or AlZnMgCu1,5 with a composition along following lines: The Si content ranges from 0% to 0.40%, the Fe content ranges from 0% to 0.50%, the Cu content ranges from 1.20% to 2.0%, the Mn content ranges from 0% to 0.30%, the Mg content ranges from 2.10% to 2.90%, the Cr content ranges from 0.18% to 0.28%, the Zn content ranges from 5.10% to 6.10%, the Ni content ranges from 0% to 0.05%, the Ti content ranges from 0% to 0.20%, the balance being Aluminium and unavoidable impurities, all percentages being percentages by weight.

A gear as described can be used for transmitting power in a car or a motor bike, particularly in a racing car or a racing motor bike. The gear transmits the power generated by the motor by means of a chain to the wheels.

### Brief Description of Figures in the Drawings

FIGURE 1 illustrates the working of a gear and a chain;
FIGURE 2 shows a perspective view of a gear according to the invention;
FIGURE 3 shows an enlarged view of a gear according to the invention;
FIGURE 4 is a schematic illustration of the coating structure covering teeth of the gear.

### Mode(s) for Carrying Out the Invention

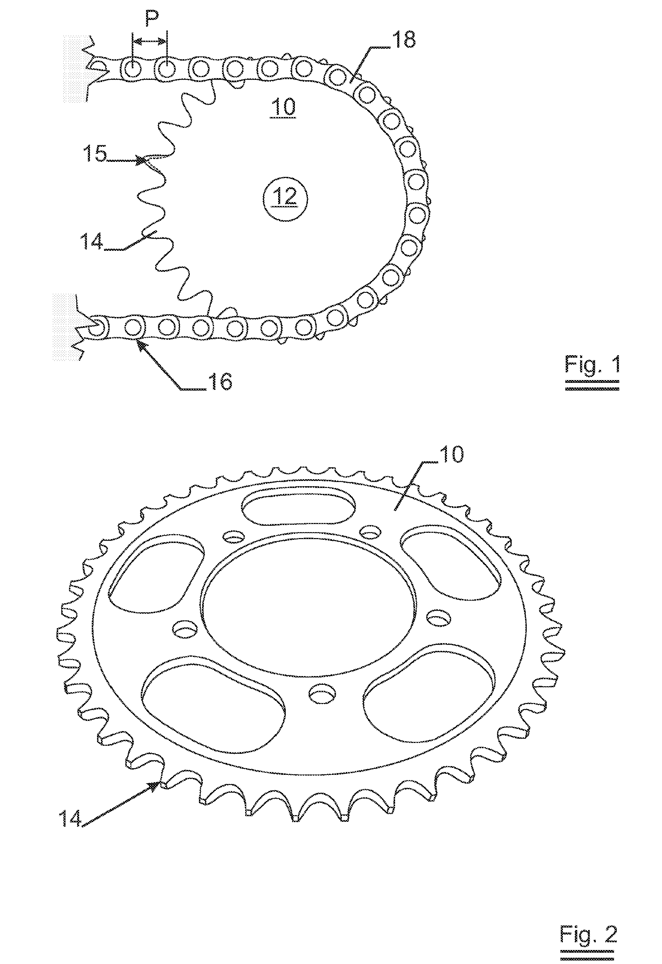

FIGURE 1 illustrates the principle working of a gear and a chain. A gear 10 is driven by means of a motor (not shown) which generates power and transmits this power to gear 10 by means of axle 12. Gear 12 has a plurality of teeth 14 and transmits the received power via sprocket chain 16 to the wheels (not shown) of a car or of a motor bike. The sprocket chain has a plurality of links 18 which fit onto the teeth 14.

In the case of the prior art embodiment, gear 12 with the teeth 14 is made out of an aluminium alloy. The teeth 14 are not covered with a hard coating. Due to the high level of power transmitted, due to the strong forces between the teeth and the links, due to the relatively soft aluminium substrate of the teeth 14 coming each time into hard contact with the links 18 of the chain 16 and due to the high degree of friction between the teeth 14 and the links 18, the teeth 14 are subject to substantial wear. This wear is so pronounced that the teeth 14 loose their initial shape and become more sharp, as illustrated by the dotted lines shown by arrow 15. In addition to the wear caused at the teeth, the chain 16 is also subject to substantial wear. The pitch P, which is the distance between two pivoting points of a link 18, increases. As a result of this increase in pitch P, the links 18 no longer fit smoothly on the teeth 14 and an even greater amount of wear is caused. Summarizing, this prior art power transmitting system is highly instable and self-destructing leading to a limited life time.

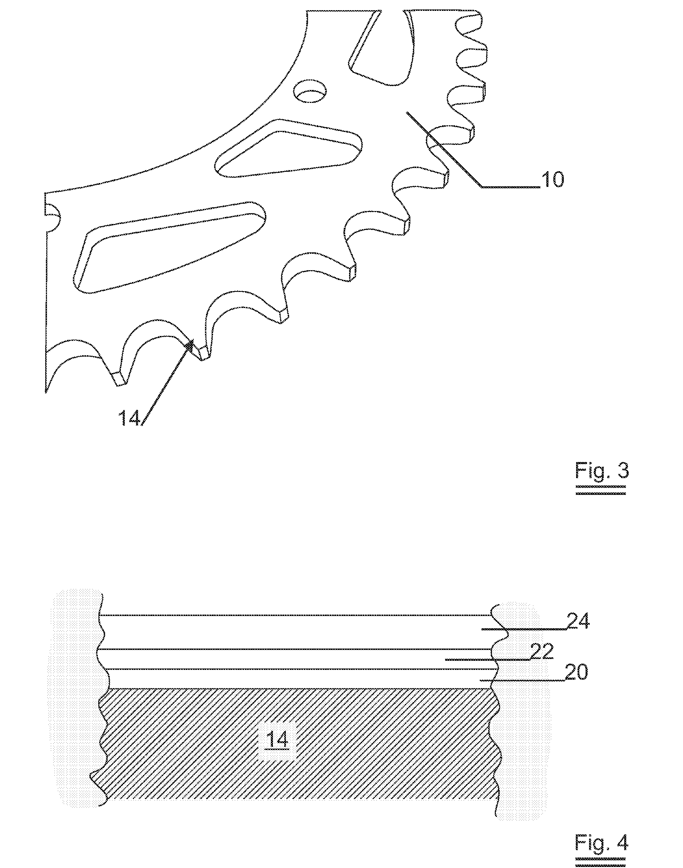

FIGURE 2 shows a gear 10 according to the invention and FIGURE 3 shows an enlarged view of gear 10 according to the invention. The teeth 14 are at least partially covered with a layered coating having an intermediate coating and a hard carbon coating on top of it. Preferably the layered coating covers all parts of the teeth 14 which come into contact with the chain. From a practical point of view, however, much more surface of the gear gets coated in the CVD process or PACVD process.

FIGURE 4 is a schematic presentation of a layered coating on the aluminium substrate of gear 14.
The intermediate coating 20 is a Ti coating deposited by means of a vacuum sputtering process. The thickness of this titanium layer is e.g. 200 nm.
A DLN layer 22 is deposited on top of the intermediate coating 20. The thickness of this DLN layer is e.g. 200 nm.
A DLC layer 24 is deposited on top of the DLN layer 22. The DLC layer is thicker than 500 nm.

## Claims

1. A gear adapted to transmit power in a car or a motor bike, said gear being made of an aluminium alloy, said gear comprising teeth, said teeth being at least partially covered with a layered coating, said layered coating comprising an intermediate coating and a hard carbon coating on top of said intermediate coating, said intermediate coating comprising a metal layer comprising at least one element of group IVB, group VB or group VIB.

2. A gear according to claim 1, wherein said one element is titanium.

3. A gear according to claim 1 or claim 2, wherein said intermediate coating further comprises a nitride layer deposited on said metal layer, said nitride layer comprising at least one nitride of an element of group IVB, group VB or group VIB.

4. A gear according to any one of the preceding claims, wherein said hard carbon coating comprises a layer with a diamond-like nanocomposite composition and a layer with a diamond-like carbon composition.

5. A gear according to any one of the preceding claims, wherein said intermediate coating has a thickness ranging from 10 nm to 1000 nm.

6. A gear according to claim 4 or to claim 5, wherein said layer with a diamond-like nanocomposite composition has a thickness ranging from 20 nm to 2000 nm.

7. A gear according to any one of claims 4 to 6, wherein said layer with a diamond-like carbon composition lies on top of said layer with a diamond-like nanocomposite composition.

8. A gear according to claim 7, wherein said layer with a diamond-like carbon composition has a thickness greater than 100 nm.

9. A gear according to any one of the preceding claims, wherein said aluminium alloy is AIZnMgCu1.5.

10. A motor bike or a car comprising a gear according to any one of the preceding claims.
